# EUROPEAN PATENT APPLICATION

(11) **EP 1 926 138 A1**
(43) Date of publication of application: **28.05.2008**
(21) Application number: 05772572.3
(22) Date of filing: 18.08.2005
(51) Int. Cl.: H01L 21/66, H01L 21/822, H01L 27/04

(54) **DEVICE IDENTIFYING METHOD, DEVICE MANUFACTURING METHOD AND ELECTRONIC DEVICE**

(71) Applicant: ADVANTEST CORPORATION, Nerima-ku, Tokyo 179-0071 (JP); National University Corporation Tohoku Unversity, Sendai-shi, Miyagi 9808577 (JP)
(72) Inventor: OKAYASU, Toshiyuki, Nerima-ku, Tokyo 1790071 (JP); SUGAWA, Shigetoshi, Sendai-shi, Miyagi 9808577 (JP); TERAMOTO, Akinobu, Sendai-shi, Miyagi 9808577 (JP)
(74) Representative: Pfenning, Meinig & Partner GbR
(86) International application number: PCT/JP2005/015093
(87) International publication number: WO 2007/020698

(57) **Abstract**

Provided is a device identifying method for identifying an electronic device including an actual operation circuit operating at a time of actual operation of the electronic device and a test circuit provided with a plurality of test elements and operating at a time of testing of the electronic device, the device identifying method including: a property measuring step of measuring electric properties respectively of the plurality of test elements; an identification information storing step of storing the electric properties respectively of the plurality of test elements, as identification information of the electronic device; an identification information obtaining step of measuring, in an attempt to identify a target electronic device, electronic properties of a plurality of test elements included in the target electronic device, thereby obtaining identification information of the target electronic device; and a matching step of comparing the identification information obtained in the identification information obtaining step and the identification information stored in the identification information storing step, and judging that, when there is matching in identification information, the target electronic device whose identification information is obtained in the identification information obtaining step is the electronic device whose identification information is stored in the identification information storing step.

## Description

### TECHNICAL FIELD

The present invention relates to an electronic device such as a semiconductor circuit, a device identifying method for identifying an electronic device, and a device manufacturing method for manufacturing an electronic device. In particular, the present invention relates to an electronic device provided with a test circuit such as a TEG (Test Element Group), and a device identifying method and a device manufacturing method regarding the electronic device.

### BACKGROUND ART

Conventionally, in manufacturing an electronic device such as a semiconductor circuit, a plurality of electronic devices are formed on one wafer, and the wafer is cut into each electronic device. This makes it difficult to identify each electronic device as to which wafer and in which position the electronic device is formed or the like, after cutting the wafer. Accordingly, when an electronic device has caused a malfunction or a failure, it becomes difficult to analyze the cause.

Regarding this problem, a technology of assigning identification information to an electronic device is known. For example, a method of assigning an optical identifier to a surface of each electronic device, a method of causing each electronic device to electrically memorize identification information and the like are known.

We have not recognized any related patent documents or the like, and so the description thereof is omitted here.

### DISCLOSURE OF THE INVENTION

### PROBLEMS TO BE SOLVED BY THE INVENTION

However, a conventional identifying method necessitates means for retaining the identification information in addition to circuits normally provided for an electronic device. This deteriorates an area efficiency, a manufacturing efficiency, or the like, for an electronic device.

In view of this, an object of the present invention is to provide an electronic device identifying method, an electronic device manufacturing method, and an electronic device, which are able to overcome the above drawbacks accompanying the conventional art. The above object can be achieved by combinations described in the independent claims. The dependent claims define further advantageous and exemplary combinations of the present invention.

### MEANS FOR SOLVING THE PROBLEMS

In order to overcome the above drawbacks, according to a first aspect of the present invention, provided is a device identifying method for identifying an electronic device including an actual operation circuit operating at a time of actual operation of the electronic device and a test circuit provided with a plurality of test elements and operating at a time of testing of the electronic device, the device identifying method including: a property measuring step of measuring electric properties respectively of the plurality of test elements; an identification information storing step of storing the electric properties respectively of the plurality of test elements, as identification information of the electronic device; an identification information obtaining step of measuring, in an attempt to identify a target electronic device, electronic properties of a plurality of test elements included in the target electronic device, thereby obtaining identification information of the target electronic device; and a matching step of comparing the identification information obtained in the identification information obtaining step and the identification information stored in the identification information storing step, and judging that, when there is matching in identification information, the target electronic device whose identification information is obtained in the identification information obtaining step is the electronic device whose identification information is stored in the identification information storing step.

Moreover, it is possible to arrange so that in the property measuring step, the electric properties of the plurality of test elements are measured in a state where a plurality of electronic devices are formed on a same wafer, and in the identification information obtaining step, the electronic properties of the plurality of test elements are measured in a state where the wafer is cut to separate the plurality of electronic devices from each other.

Moreover, it is possible to arrange so that in the identification information storing step, information indicating, for each test element, whether the electric property of the test element is larger than a predetermined first reference value is stored as the identification information, and in the identification information storing step, information indicating, for each test element, whether the electric property of the test element is larger than a second reference value that is different from the first reference value is obtained as the identification information.

Moreover, it is possible to arrange so that the device identifying method further includes an evaluation step of, when there is matching in identification information in the matching step, evaluating deterioration of the target electronic device based on a difference between the electric properties measured in the property measuring step and the electric properties measured in the identification information obtaining step.

According to a second aspect of the present invention, provided is a device manufacturing method of manufacturing an electronic device including an actual operation circuit operating at a time of actual operation of the electronic device and a test circuit provided with a plurality of test elements and operating at a time of testing of the electronic device, the device manufacturing method including: an actual circuit forming step of forming the actual operation circuit of each electronic device on a wafer; a first test circuit forming step of forming a first test circuit on a cutting line at which the wafer is cut into each electronic device; a second test circuit forming step of forming a second test circuit in a different area from the cutting line of the wafer; a property measuring step of measuring electric properties of the test elements included in each test circuit; an identification information storing step of storing electronic properties of test elements included in the second test circuit from among the electronic properties measured in the property measuring step, as identification information of a corresponding electronic device; and an cutting step of cutting the wafer into each electronic device.

Moreover, it is possible to arrange so that in the identification information storing step, the identification information of each electronic device is stored in association with a position of the electronic device on the wafer.

According to a third aspect of the present invention, provided is an electronic device including: an actual operation circuit that operates at a time of actual operation of the electronic device; a third test circuit and a second test circuit that operate at a time of testing of the electronic device; and a power supply section that, at the time of actual operation of the electronic device, applies a power supply voltage to the actual operation circuit and the third test circuit while maintaining a state of not applying a power supply voltage to the second test circuit, and that, at a time of identifying the electronic device, applies a power supply voltage to the second test circuit.

Moreover, it is possible to arrange so that the power supply section applies substantially the same power supply voltage both to the actual operation circuit and the third test circuit, or that the third test circuit and the second test circuit have substantially the same circuitry configuration as each other.

Moreover, it is possible to arrange so that the second test circuit includes: a plurality of test elements provided to be electrically parallel; a selecting section that controls each test element to the ON state sequentially at the time of testing of the electronic device; and an identification information outputting section that outputs each terminal voltage of each test element controlled to the ON state sequentially by the selecting section, as identification information of the electronic device.

Moreover, it is possible to arrange so that the third test circuit includes: a plurality of test elements provided to be electrically parallel; a selecting section that controls each test element to the ON state sequentially at the time of testing of the electronic device; a property outputting section that sequentially outputs the terminal voltage of each test element controlled to the ON state sequentially by the selecting section; and a state maintaining section that maintains the plurality of test elements to the ON state at the time of actual operation of the electronic device.

The summary of the invention does not necessarily describe all necessary features of the present invention. The present invention may also be a sub-combination of the features described above.

### EFFECT OF THE INVENTION

According to some embodiments of the present invention, it is possible to obtain information for identifying an electronic device. In addition, a dedicated configuration for assigning identification information to an electronic device is not necessary, because the electric property of a test element provided for evaluating a property of an electronic device is stored as identification information. This contributes to improvement in area efficiency, manufacturing efficiency, or the like, for an electronic device.

### BRIEF DESCRIPTION OF THE DRAWINGS

Fig. 1 shows a configuration of a measuring apparatus 100 according to an embodiment of the present invention.
Fig. 2 shows one example of an electronic device 510 formed on a wafer 500.
Fig. 3 shows one example of a configuration of a test circuit 300.
Fig. 4 is a flowchart showing one example of a device identifying method for measuring a threshold voltage for each test element 314, and generating identification information of an electronic device 510.
Fig. 5 shows one example of identification information of an electronic device 510 stored by an identification information storage section 20.
Fig. 6 is a flowchart showing one example of an evaluation method for evaluating deterioration of each electronic device 510.
Figs. 7A and 7B show one example of a method for generating identification information, which is performed by a property measuring section 16, where Fig. 7A corresponds to a case where identification information is generated in the state where a plurality of electronic devices 510 are formed on the same wafer 500, and Fig. 7B corresponds to a case where identification information is generated in the state where each electronic device 510 is separate after the wafer 500 has been cut.
Fig. 8 is a flowchart showing one example of a device identifying method for measuring a current-voltage property of each test element 314, and generating identification information of the electronic device 510.
Fig. 9 is a flowchart showing one example of a device identifying method for measuring a PN junction leak current for each test element 314, and generating identification information of the electronic device 510.
Fig. 10 shows another example of a configuration of each cell 310 included in a test circuit 300.
Fig. 11 is a flowchart showing one example of a device identifying method for measuring a gate leak current for each test element 372, and generating identification information of the electronic device 510.
Fig. 12 shows another example of a configuration of a cell 310.
Fig. 13 explains a device manufacturing method for manufacturing the electronic device 510.
Fig. 14 shows another example of a configuration of the electronic device 510.

### BEST MODE FOR CARRYING OUT THE INVENTION

The invention will now be described based on the preferred embodiments, which do not intend to limit the scope of the present invention, but exemplify the invention. All of the features and the combinations thereof described in the embodiment are not necessarily essential to the invention.

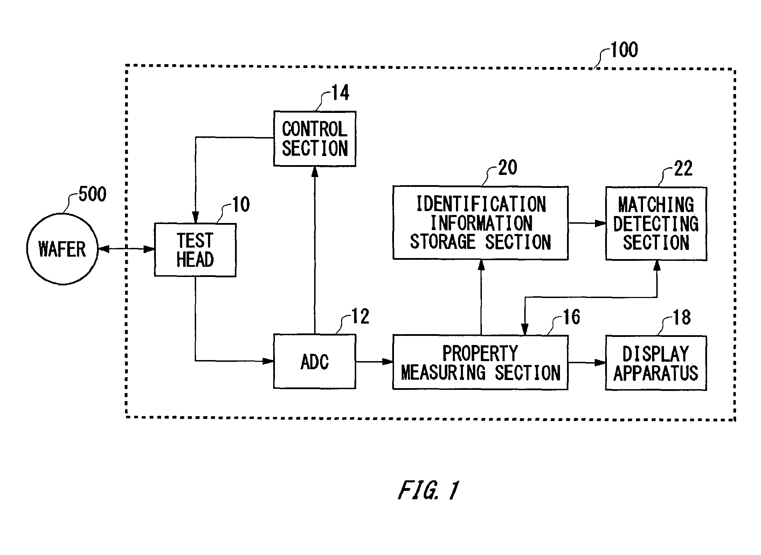

Fig. 1 shows a configuration of a measuring apparatus 100 according to an embodiment of the present invention. The measuring apparatus 100 is an apparatus for measuring an electric property of a wafer 500 on which a plurality of electronic devices are formed. The measuring apparatus 100 includes a test head 10, an ADC 12, a control section 14, a property measuring section 16, a display apparatus 18, an identification information storage section 20, and a matching detecting section 22.

The teat head 10 is electrically connected to a plurality of electronic devices provided on the wafer 500, and performs transmission and reception of a signal with a test circuit which is formed on the electronic device. The control section 14 controls a test circuit of each electronic device via the test head 10. The ADC 12 converts a signal outputted from each test circuit via the test head, into digital data.

The property measuring section 16 measures an electric property of each test circuit, based on the digital data outputted form the ADC 12. For example, the property measuring section 16 measures electric properties of a plurality of test elements included in the test circuit. The test element is a transistor for example, and the property measuring section 16 measures a threshold voltage, a current-voltage property, a leak current, and the like of each test element.

It is possible to judge whether each electronic device passes or fails the test, based on the electric properties measured by the property measuring section 16. For example, it is possible to judge, for each electronic device, whether the electronic device passes or fails the test, based on variations of the electric properties of the test elements included in the electronic device.

The display apparatus 18 displays the electric property of each test element. For example, the display apparatus 18 displays property information according to a voltage value of a threshold voltage for each test element, on coordinates corresponding to each test element in the display surface of the display apparatus 18.

The identification information storage section 20 stores, for each electronic device, electric properties of test elements included in the electronic device, as identification information of the electronic device. For example, the identification information storage section 20 compares a value of an electric property for each test element with a predetermined reference value, and stores the comparison result as identification information. Here, the identification information storage section 20 may store identification information of each electronic device by associating the identification information with a lot number of the wafer 500, the identification number of the wafer 500 (e.g. serial number of the wafer 500), the position of the electronic device on the wafer 500, the value of the electric property measured by the property measuring section 16, or the like. In addition, when storing identification information, it is desirable that the property measuring section 16 measures the electric property of the test element in the state where a plurality of electronic devices are formed on the same wafer 500.

According to the stated configuration, it is possible to obtain information for identifying an electronic device. Moreover, the configuration enables to store, as identification information, an electric property for a test element provided for property evaluation of an electronic device, and so it becomes unnecessary to provide a dedicated configuration for assigning identification information to an electronic device. Accordingly, it is possible to improve an area efficiency, a manufacturing efficiency, or the like of an electronic device.

In addition, the measuring apparatus 100 stores identification information of an electronic device, in association with a manufacturing history such as the lot number of the electronic device and the position of the electronic device on a wafer 500. The measuring apparatus 100 may measure an electric property of a test circuit included in an electronic device at a plurality of timings within a manufacturing process of the electronic device. The electric property may then be stored in association with the identification information of the electronic device. According to the stated configuration, when an electronic device has caused a malfunction, a failure, or the like, it becomes possible to investigate the manufacturing history of the electronic device having caused a malfunction or the like, by detecting identification information of the electronic device and comparing the same with identification information having been stored in advance. As a result, it becomes possible to perform detailed analysis of a malfunction or the like.

For example, when an electronic device has caused a malfunction, a failure, or the like after the wafer 500 has been cut to be separated into devices, the measuring apparatus 100 measures the electric properties of the test circuits of the electronic device. The operation of the measuring apparatus 100 in this case is the same as the operation in the case of measuring a device before separation. For example, the property measuring section 16 measures the electric properties of the plurality of test elements included in the test circuit of the electronic device. Then the property measuring section 16 obtains the identification information of the electronic device based on the electronic properties.

The matching detecting section 22 compares the identification information obtained by the property measuring section 16 with identification information stored in the identification information storage section 20 in advance, to detect which identification information the identification information obtained by the property measuring section 16 matches. When there is matching in identification information, the matching detecting section 22 judges that they are the same electronic device. According to this configuration, it is possible to identify each electronic device even after the wafer 500 is cut to separate devices, thereby enabling to investigate the manufacturing history of the electronic device.

For example, when an electronic device has caused a failure or the like after having been shipped to market and used, a supplier of the electronic device will collect the electronic device and performs a failure analysis thereto. In this case, it becomes necessary to investigate a manufacturing history of the electronic device (i.e. a history with which the electronic device has been manufactured). According to the measuring apparatus 100 of the present example, it becomes possible to easily investigate such a manufacturing history of an electronic device based on the identification information of the electronic device. In addition, since the test circuit does not operate at the time of actual operation of the electronic device, the fluctuation of an electric property of a test element included in the test circuit is small. For this reason, it becomes possible to accurately identify an electronic device.

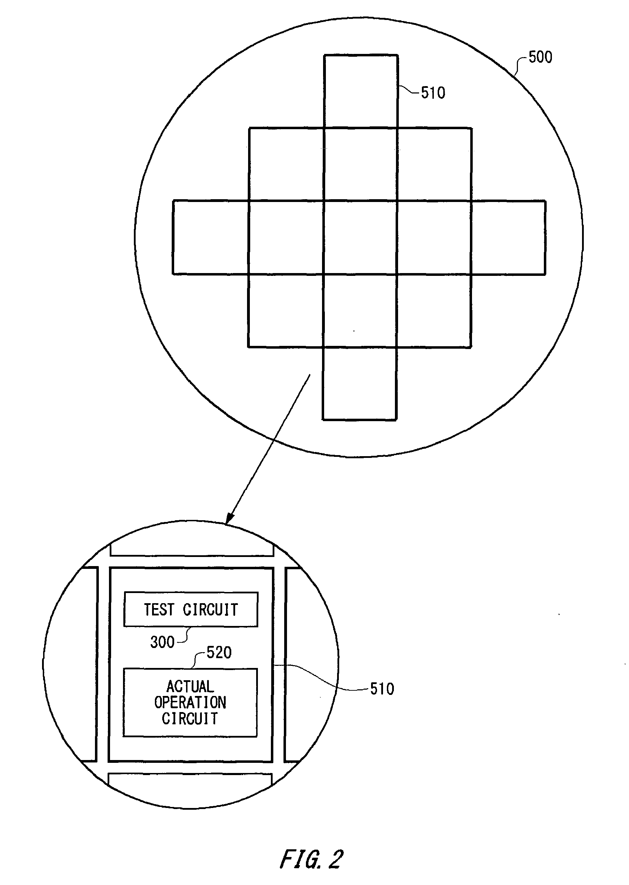

Fig. 2 shows one example of an electronic device 510 formed on a wafer 500. As shown in Fig. 2, a plurality of electronic devices 510 are formed on the wafer 500. The electronic device 510 is a device that includes a semiconductor circuit for example.

The electronic device 510 includes an actual operation circuit 520 operating at the time of actual operation of the electronic device 510, and a test circuit 300 operating at the time of testing of the electronic device 510. "at the time of testing of an electronic device 510" includes a case of obtaining identification information of the electronic device 510. The test circuit 300 is provided with a plurality of test elements. For example, the test circuit 300 may include a plurality of transistors as a plurality of test elements.

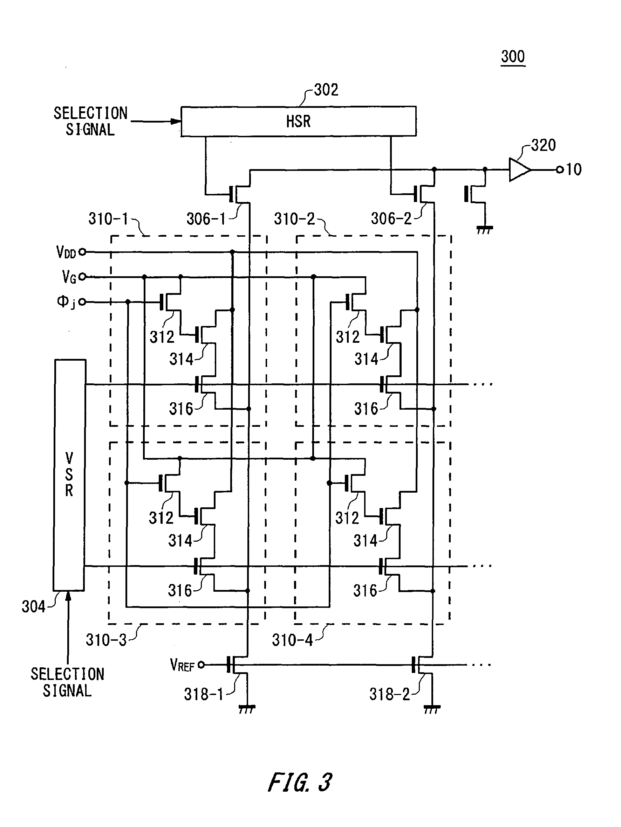

Fig. 3 shows one example of the configuration of the test circuit 300. The test circuit 300 includes a column selecting section 302, a row selecting section 304, a plurality of column selecting transistors (306-1, 306-2, hereinafter collectively referred to as 306), a plurality of current supplies (318-1, 318-2, hereinafter collectively referred to as 318), an output section 320, and a plurality of cells (310-1- 310-4, hereinafter collectively referred to as 310). The column selecting transistors 306 and the current supply 318 are provided for each group of cells 310 provided in the row direction.

The plurality of cells 310 are provided to be parallel to each other, along the row direction and the column direction that form a row-column matrix within the surface of the wafer 500. The present example shows a circuit in which two cells 310 are provided in the row direction and in the column direction respectively, however it is possible to provide a multitude of cells 310 in the row direction and in the column direction respectively. For example, the test circuit 300 has 128 cells in the row direction and 512 cells in the column direction.

Each cell 310 includes a test element 314, a switching transistor 312, and a row selecting transistor 316. Each transistor in each cell 310 may be a MOS transistor formed by a same process as in the case of the actual operation transistor included in the actual operation circuit 520 of the electronic device 510.

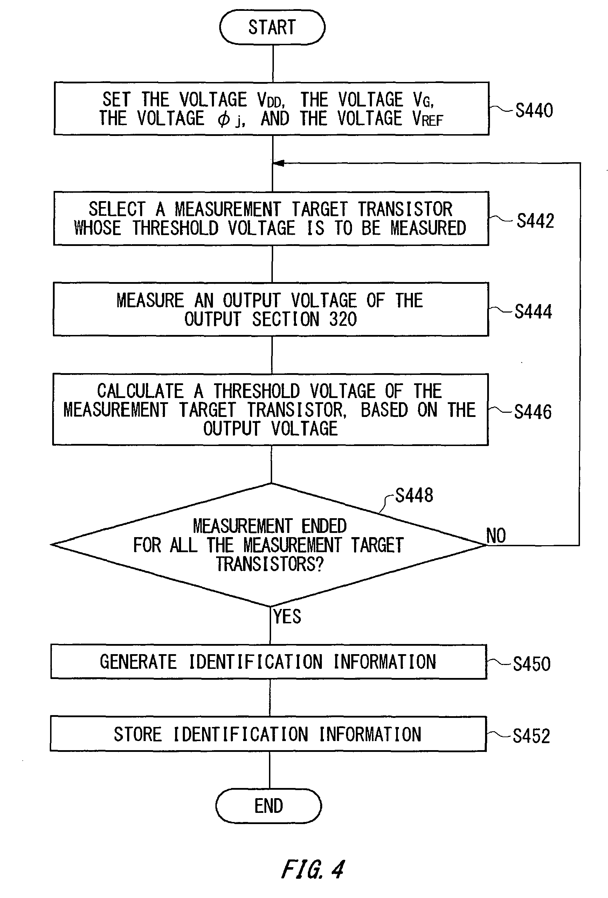

The test element 314 in each cell 310 is provided to be electrically parallel to each other. The drain terminal of each test element 314 is supplied with a predetermined voltage V_{DD}. Although a well voltage terminal (i.e. terminal that supplies a well voltage) for the test element 314 is not illustrated, the well voltage terminal may be connected to a ground potential, or may be arranged so that the well voltage be independently controllable according to each transistor, and that the well voltage terminal of the test element 314 and the source terminal may be connected to each other. In addition, the test element 314 may be either an NMOS transistor or a PMOS transistor. The voltage V_{DD}, the voltage V_{G}, the voltage ϕⱼ, and the voltage V_{REF} shown in Fig. 4 may be supplied by the control section 14 shown in Fig. 1 to the test circuit 300.

The switching transistor 312 in each cell 310 is provided to correspond to the test element 314 of each cell, to apply a predetermined gate voltage to the gate terminal of the corresponding test element 314. In the switching transistor 312 in the present example, the drain terminal is provided with a predetermined voltage V_{G}, the gate terminal is provided with a voltage ϕⱼ for controlling the operation of the switching transistor 312, and the source terminal is connected to the gate terminal of the test element 314. That is, the switching transistor 312, when controlled to the ON state by the voltage ϕⱼ, applies a voltage that is substantially equal to the voltage V_{G} to the gate terminal of the test element 314. When controlled to the OFF state, the switching transistor 312 applies a floating voltage whose initial voltage is substantially V_{G} to the gate terminal of the test element 314.

Fig. 3 has dealt with an example of collectively applying the voltage ϕⱼ to all the cells 310. However in other examples, it may be arranged so that the voltage ϕⱼ is sequentially applied to each cell 310 arranged in the row direction from the row selecting section 304 as a pulse signal, so as to equalize the leak time at the time of measuring the PN junction leak current across all the cells.

The row selecting transistor 316 in each cell 310 is provided to correspond to the test element of each cell. In the present example, the drain terminal of each row selecting transistor 316 is connected to the source terminal of the test element 314. In addition, the source terminal of the row selecting transistor 316 is connected to the source terminal of a corresponding column selecting transistor 306. That is, the source terminal of each column selecting transistor 306 is connected to the source terminals of a plurality of corresponding row selecting transistors 316.

The row selecting section 304 sequentially selects a plurality of groups of cells 310 (i.e. cell groups (310-1, 310-2) and cell groups (310-3, 310-4) in the present example) provided in the row direction. In addition, the column selecting section 302 sequentially selects a plurality of groups of cells 310 (i.e. cell groups (310-1, 310-3) and cell groups (310-2, 310-4) in the present example) provided in the column direction. According to such a configuration, the row selecting section 304 and the column selecting section 302 sequentially select each cell 310.

In the present example, the row selecting section 304 controls the row selecting transistors 316 provided for the cell groups in the row direction to the ON state sequentially, according to a position in the row direction according to a selection signal given by the control section 14. In addition, the column selecting section 302 controls the column selecting transistors 306 provided for the cell groups in the column direction to the ON state sequentially, according to a position in the column direction according to a selection signal given by the control section 14. The control section 14 supplies a selection signal for sequentially selecting each cell 310, to the row selecting section 304 and the column selecting section 302. In addition, the column selecting section 302 and the row selecting section 304 may be a circuit for converting a given selection signal into a positional signal indicating a position of a cell 310 to be selected, such as a decoder and a shift register. Here, the positional signal is a signal for controlling a column selecting transistor 306 and a row selecting transistor 316 corresponding to the cell 310 to be selected according to a selection signal, to the ON state.

The stated configuration enables to sequentially select test elements 314 provided for cells 310 respectively. Then the source voltages for the sequentially selected test elements 314 are sequentially supplied to the output section 320. The output section 320 sequentially outputs supplied source voltages to the test head 10. The output section 320 is a voltage follower buffer for example. The measuring apparatus 100 measures the electric property (e.g. threshold voltage, current-voltage property, low-frequency noise, PN junction leak current) of each test element 314 based on the source voltage of the test element 314.

In addition, each current supply 318 is a MOS transistor receiving a predetermined voltage V_{REF} at the gate terminal thereof. The drain terminal of each current supply 318 is connected to the source terminal of a plurality of corresponding row selecting transistors 316. That is, each current supply 318 is commonly provided for a plurality of test elements 314 provided in substantially the same position in the row direction, and defines the source-drain current running to the corresponding test elements 314.

According to the circuitry configuration shown in Fig. 3, it is possible to electrically and sequentially select a plurality of test elements 314 in each test circuit 300, and to sequentially output the source voltages of the selected test elements 314, thereby enabling to measure the source voltage of each test element 314 in a short time and at high speed. Accordingly, even in a case where a multitude of test elements 314 are provided on a wafer 500, it becomes possible to perform measurement for all the test elements 314 in a short time. In the present example, about ten thousands (10,000) to ten million (10,000,000) test elements 314 may be provided within a surface of the wafer 500. By performing measurement to a multitude of test elements 314, it becomes possible to accurately calculate variations of the properties of the test elements 314.

Fig. 4 is a flowchart showing one example of a device identifying method for measuring a threshold voltage for each test element 314, and generating identification information of an electronic device 510. This device identifying method includes property measuring (S440 - S448), identification information generating S450, and identification information storing S452.

First, the control section 14 supplies the voltage V_{DD}, the voltage V_{G}, the voltage ϕⱼ, and the voltage V_{REF} described above with reference to Fig. 3, to the test circuit 300 (S440). During this operation, the control section 14 supplies a constant voltage V_{REF} to each current supply 318, to cause each current supply 318 to generate a same constant current. In addition, the control section 14 supplies a gate voltage V_{G} for controlling a test element 314 to the ON state, and supplies a voltage ϕⱼ for controlling each switching transistor 312 to the ON state. According to the stated control, the control section 14 controls to apply a gate voltage to the gate terminal of each test element 314, for controlling the test element 314 to the ON state.

Next, the control section 14 supplies a selection signal for selecting a test element 314 whose threshold voltage is to be measured, to the column selecting section 302 and the row selecting section 304 (S442). Then the ADC 12 measures the output voltage of the output section 320 (S444). The ADC 12 may notify the control section 14 of a fact that the output voltage has been measured. The control section 14 may select the next test element 314 upon reception of the notification.

Next, the property measuring section 16 calculates the threshold voltage of each test element 314, based on the gate voltage V_{G} applied to the test element 314 and the output voltage of the output section 320 (S446). The threshold voltage of a test element 314 is able to be obtained by calculating a difference between the gate voltage V_{G} and the output voltage, i.e. the gate-source voltage for the test element 314.

Next, the control section 14 judges whether the threshold voltage has been measured with respect to all the test elements 314 (S448). If there is any test element 314 left unmeasured, the control section 14 selects the next test element 314, and repeats the processing of S444 - S446. When the threshold voltages of all the test elements 314 have been measured, the property measuring section 16 generates identification of the electronic device 510 based on the threshold voltage of each test element 314. Then the identification information storage section 20 stores the identification information of the electronic device 510 (S452).

According to the stated operation, it is possible to generate identification information of an electronic device 510, and store the identification information of the electronic device 510. In addition, since the identification information is generated based on the electric property of the test circuit 300 used in testing the electronic device 510, it is possible to identify the electronic device 510 even without newly providing the electronic device 510 with means for retaining the identification information.

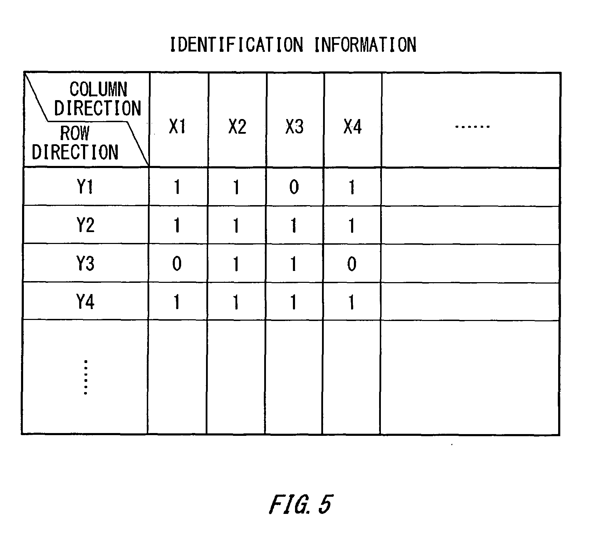

Fig. 5 shows one example of identification information of an electronic device 510 stored by an identification information storage section 20. The property measuring section 16 generates identification information, based on the electric properties of the test elements 314 provided in a matrix formation, for example as shown in Fig. 3. The property measuring section 16 may generate identification information, based on a result of comparing the property value of the electric property (e.g. threshold voltage) of each test element 314 with a predetermined reference value. For example, as shown in Fig. 5, a matrix of identification information is generated, where 1 is assigned for a test element 314 whose property value is larger than the reference value, 0 is assigned for a test element 314 whose property value is smaller than the reference value. In addition, other than creating a binary value by comparing the electric property value with a reference value, it is alternatively possible to store the electric property value as it is as identification information, or to extract a characteristic in the pattern of the electric property value and store the characteristic as identification information. For example, it is possible to extract the characteristic by creating a binary value of the electric property value as described above, or to extract the characteristic in the two dimensional pattern of the electric property value for the test element 314. Still further, these types of identification information may be subjected to data compression before being stored.

By generating identification information of the electronic device 510 based on the electric properties of a multitude of test elements 314, it becomes possible to generate a different piece of identification information for each electronic device 510. In addition, the identification information storage section 20 may store the identification information after compression. For example, the identification information storage section 20 may store positions on the matrix where the data value of the identification information is 0. For example, in the present example, [X1, Y3], [X3, Y1], [X4, Y3] may be stored.

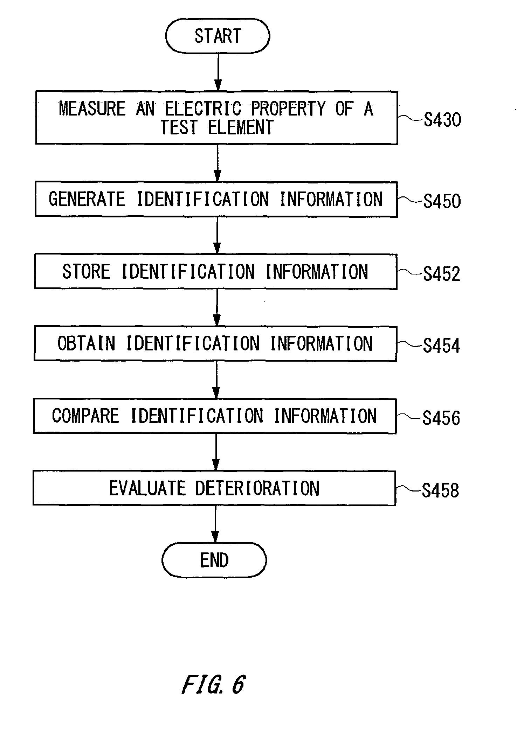

Fig. 6 is a flowchart showing one example of an evaluation method for evaluating deterioration of each electronic device 510. In Fig. 6, S430 for measuring an electric property of a test element may be performed by processing of S440 - S448 described above with reference to Fig. 4, for example. In addition, the processing of S450 and S452 in Fig. 6 is the same as the processing of S450 and S452 explained above with reference to Fig. 5.

In evaluating a desired electronic device 510, the electric properties of the plurality of test elements 314 included in the electronic device 510 are measured, to obtain identification information of the electronic device 510 (identification information obtaining S454). The electronic device 510 meant here is one of separate electronic devices 510 resulting from cutting the wafer 500 for example.

Next, the obtained identification information is compared to identification information stored by the identification information storage section 20. When there is matching in identification information, the electronic device 510 whose identification information is obtained in the identification information obtaining S454 is judged to be the same as the electronic device 510 corresponding to the identification information stored by the identification information storage section 20 (matching S456). Then when there is matching in identification information in the matching S456, the deterioration of the electronic device 510 is evaluated based on a difference between the electric property measured in the property measuring S430 and the electric property measured in the identification information obtaining S454 (evaluation S458). According to the stated processing, it is possible to evaluate the deterioration of the electronic device 510.

In addition, a plurality of test elements 314 included in an electronic device 510 may be divided into a plurality of groups, may be formed from different process rules or device sizes according to each group, and may be formed in different forms or in different orientations according to each group. According to this arrangement, it is possible to evaluate the device deterioration, such as each device size, included in the actual operation circuit in an electronic device 510.

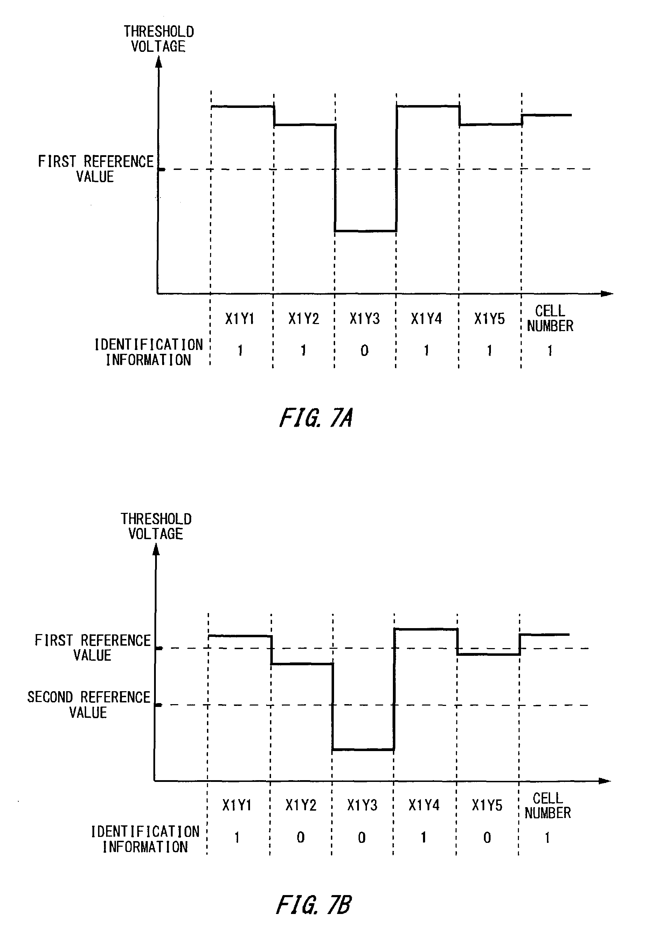

Figs. 7A and 7B show one example of a method for generating identification information, which is performed by a property measuring section 16, where Fig. 7A corresponds to a case where identification information is generated in the state where a plurality of electronic devices 510 are formed on the same wafer 500, and Fig. 7B corresponds to a case where identification information is generated in the state where each electronic device 510 is separate after the wafer 500 has been cut.

As shown in Fig. 7A, the property measuring section 16 generates identification information based on a result of comparing the threshold voltage of the test element 314 included in each cell 310 with a predetermined first reference value. As described above, the property measuring section 16 generates a matrix of identification information, where 1 is assigned for a test element 314 whose threshold voltage is larger than the first reference value, and 0 is assigned for a test element 314 whose threshold voltage is smaller than the first reference value. The identification information storage section 20 stores the identification information.

Next, for example in evaluating deterioration of the electronic device 510 collected from market, users, or the like, the property measuring section 16 obtains the identification information of the electronic device 510 based on a result of comparing a threshold voltage of the test element 314 included in each cell 310 of the electronic device 510 and a predetermined second reference value, as shown in Fig. 7B.

During this operation, a case may occur where the threshold voltages of the test elements 314 have been deteriorated depending on the usage state of the electronic device 510. In such a case, there is a possibility of obtaining erroneous identification information, if the first reference value is compared to the threshold voltages of the test elements 314, as is illustrated in Fig. 7B.

In the present example, the property measuring section 16 compares the second reference value that is different from the first reference value, to the threshold voltages of the test elements 314. For example, in obtaining identification information making use of an electric property having a tendency of decreasing as the electronic device 510 is used, the property measuring section 16 obtains identification information making use of the second reference value that is smaller than the first reference value.

The property measuring section 16 may determine the second reference value based on the threshold voltage measured when generating identification information stored in the identification information storage section 20. For example, the property measuring section 16 may detect any threshold voltages that are smaller than the first reference value from among threshold voltages measured when generating identification information stored in the identification information storage section 20, and determine the second reference value based on the maximum threshold voltage from among the detected threshold voltages. For example, a value obtained by adding a predetermined value to the threshold value, which does not exceed the first reference value, may be used as the second reference value. In the example shown in Fig. 7A, the value obtained by adding a predetermined value to the threshold voltage of the test element 314 of the cell number X1Y3 may be used as the second reference value. According to the stated control, it is possible to accurately detect the identification information of the electronic device 510 whose property has been deteriorated due to use.

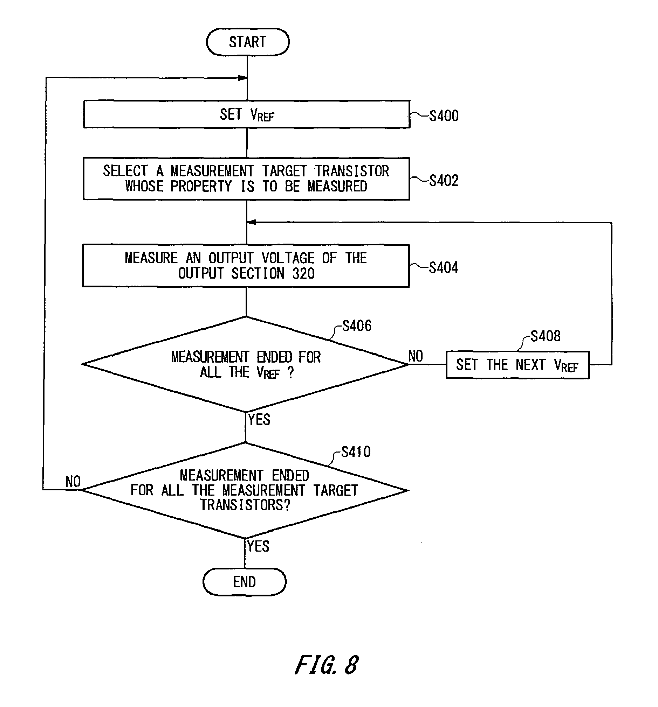

Fig. 8 is a flowchart showing one example of a device identifying method for measuring a current-voltage property of each test element 314, and generating identification information of the electronic device 510. The processing of S400 - S410 in Fig. 8 may be performed as property measuring S430 explained above with reference to Fig. 6.

First, the control section 14 supplies the voltage V_{DD}, the voltage V_{G}, the voltage ϕⱼ, and the voltage V_{REF}, explained above with reference to Fig. 3, to a test circuit 300 (S400). During this operation, the control section 14 supplies a constant voltage V_{REF} to each current supply 318, to cause each current supply 318 to generate a same constant current. In addition, the control section 14 supplies a gate voltage V_{G} for controlling a test element 314 to the ON state, and supplies a voltage ϕⱼ for controlling each switching transistor 312 to the ON state.

Next, the control section 14 supplies a selection signal for selecting a test element 314 whose current-voltage property is to be tested, to the column selecting section 302 and the row selecting section 304 (S402). Then the control section 14 changes V_{REF} by a predetermined resolution within a predetermined range (S406 - S408). During this operation, the ADC 12 measures the output voltage of the output section 320 for each V_{REF} (S404). That is, the measuring apparatus 100 sequentially changes the source-drain current generated by the current supply 318, and measures the source voltage of the test element 314 for each source-drain current. According to this, it is possible to measure the current-voltage property of the test element 314.

Then, whether the current-voltage property has been measured for all the test elements 314 is judged (S410). When there is any test element left unmeasured, the processing of S400 - S410 is repeated. During this operation, the next test element 314 is selected in S402. When the current-voltage property has been measured for all the test elements 314, the property measuring section 16 generates the identification information of the electronic device, based on each current-voltage property. For example, the property measuring section 16 may generate identification information based on the gradient, the mutual conductance gm, or the like, of each current-voltage property.

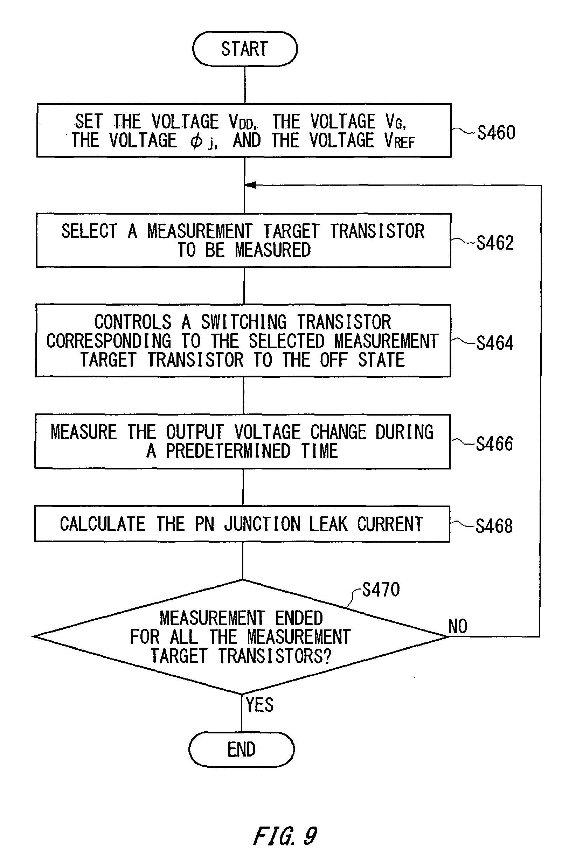

Fig. 9 is a flowchart showing one example of a device identifying method for measuring a PN junction leak current for each test element 314, and generating identification information of the electronic device 510. The processing of S460 - S470 in Fig. 9 may be performed as property measuring S430 explained above with reference to Fig. 6. In addition, each switching transistor 312 has a PN junction to be connected to a gate terminal of a corresponding test element 314. In the present example, the leak current for the PN junction is measured.

The control section 14 supplies the voltage V_{DD}, the voltage V_{G}, the voltage ϕⱼ, and the voltage V_{REF} explained above with reference to Fig. 3, to the test circuit 300 (S460). During this operation, the control section 14 supplies a constant voltage V_{REF} to each current supply 318, to cause each current supply 318 to generate a same constant current. In addition, the control section 14 supplies a gate voltage V_{G} for controlling a test element 314 to the ON state, and supplies a voltage ϕⱼ for controlling each switching transistor 312 to the ON state. In addition, by sequentially supplying a pulse signal for each cell 310 aligned in the row direction from the row selecting section 304, it becomes possible to cause a leak current measuring time for all the cells to be the same.

Next, the control section 14 supplies a selection signal for selecting a test element 314 whose PN leak current is to be tested, to the column selecting section 302 and the row selecting section 304 (S462). Then the control section 14 controls a switching transistor 312 corresponding to the selected test element 314 to the OFF state (S464). That is, the control section 14 controls each switching transistor 312 to apply a gate voltage for bringing a corresponding test element 314 to the ON state and a gate voltage for bringing the test element 314 to the OFF state, to the test element 314 sequentially.

Next, the property measuring section 16 measures the source voltage in the ON state and the source voltage after a predetermined time has elapsed after switching from the ON state to the OFF state, with respect to the test element 314 (S466). In the present example, the property measuring section 16 measures the change in output voltage of the output section 320 during the predetermined time

Next, the property measuring section 16 calculates a leak current at the PN junction, based on the change in source voltage (S468). When the switching transistor 312 is in the ON state, a charge in accordance with the gate voltage is accumulated in the gate capacity of the test element 314. Then when the switching transistor 312 is switched to the OFF state, the charge in the gate capacity will be discharged by the leak current in the PN junction. For this reason, the size of the PN junction leak current will be determined by the change amount in source voltage of the test element 314 during a predetermined time.

Next, for all the test elements 314, whether the PN junction leak current has been measured or not is judged (S470). When there is any test element 314 left unmeasured, the processing of S462 - S470 is repeated. During this operation, the next test element 314 is selected in S462. When the PN junction leak current has been measured for all the test elements 314, the property measuring section 16 generates the identification information of the electronic device, based on the PN junction leak current. For example, the property measuring section 16 generates the identification information of the electronic device, based on the current value of the PN junction leak current of each test element 314.

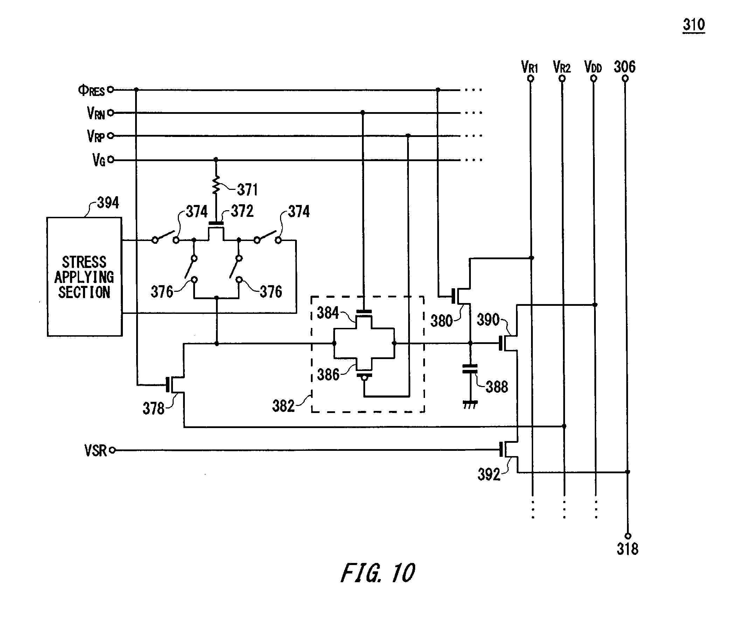

Fig. 10 shows another example of a configuration of each cell 310 included in a test circuit 300. The test circuit 300 in the present example applies an electric stress to a test element 372, and charges and discharges the integral capacity 388, by means of the gate leak current of the test element 372 in the state where a certain electric field is applied to a gate insulation film of the test element 372. Then the measuring apparatus 100 calculates the gate leak current of each test element 372, based on the change in voltage value of the integral capacity 388 for a predetermined time.

Each cell 310 includes a stress applying section 394, a test element 372, a gate voltage control section 371, a first switch 374, a second switch 376, a voltage applying section 382, an integral capacity 388, a column selecting transistor 392, reset transistors 378, 380, and a output transistor 390.

The stress applying section 394 applies an electric stress to the gate insulation film of the test element 372, via the first switch 374. For example, when the test element 372 is viewed as a memory cell of a FLASH memory, the stress applying section 394 applies a voltage for writing data to the test element 372 and for deleting data from the test element 372.

When the stress applying section 394 applies a stress, the first switch 374 connects the source terminal and the drain terminal of the test element 372 to the stress applying section 394, and the second switch 376 is brought to the OFF state. According to this control, it is possible to apply a desirable voltage to each terminal of the test element 372, thereby applying a stress thereto.

In the present example, the stress applying section 394 applies the following 4 kinds of stresses to test elements 314 independently, or sequentially.
(1) FN (Fowler-Nordheim) Gate injection
(2) FN Substrate injection
(3) Hot Electron injection
(4) Source Erase

The above (1) - (4) are methods for applying a stress to a test element 372, by writing data to the test element 372 or deleting the data of the test element 372. Here, the stress applying section 394 may apply a voltage for writing data to the test element 372 or for deleting data of the test element 372 at the time of actual operation, to each terminal of the test element 372. Still alternatively, the stress applying section 394 may apply a larger voltage than a voltage to be applied at the time of actual operation to each terminal of the test element 372.

In addition, each cell 310 is supplied with a reset signal ϕ_{RES}, control voltages V_{RN}, V_{RP}, V_{R1}, V_{R2}, V_{DD}, and a gate voltage V_{G} from the control section 14. The gate voltage control section 371 applies a predetermined gate voltage V_{G} supplied from the control section 14, to the gate terminal of the test element 372.

The second switch 376 switches between whether or not to connect the source terminal and the drain terminal of the test element, to the integral capacity via the voltage applying section 382. The voltage applying section 382 applies a constant voltage to the source terminal and the drain terminal of the test element 372 via the second switch 376. When the second switch 376 is in the ON state, the voltage generated by the voltage applying section 382 is applied to the source terminal and the drain terminal of the test element 372. That is, the voltage applying section 382 controls the electric field applied to the gate insulation film of the test element 372 to be substantially constant, by applying a constant voltage to the source terminal and the drain terminal of the test element 372.

The voltage applying section 382 includes an NMOS transistor 384 and a PMOS transistor 386. The NMOS transistor 384 is supplied with a voltage V_{RN} that is in accordance with a voltage to be applied to the source terminal and the drain terminal of the test element 372, where the source terminal is connected to the source terminal and the drain terminal of the test element 372 via the second switch 376, and the drain terminal is connected to the integral capacity 388. In addition, the PMOS transistor 386 is provided in parallel to the NMOS transistor 384, and is supplied with a gate voltage V_{RP} that is in accordance with a voltage to be applied to the source terminal and the drain terminal of the test element 372, where the drain terminal is connected to the source terminal and the drain terminal of the test element 372 via the second switch 376, and the source terminal is connected to the integral capacity 388. The NMOS transistor 384 and the PMOS transistor 386 function to maintain the voltage applied to the gate-source or the gate-drain of the test element 372 to be substantially constant, even if the gate leak current is integrated in the integral capacity 388 to change the potential.

According to the stated configuration, even if the test element 372 is P-type or N-type, it is possible to apply a constant electric field to the gate insulation film of the test element 372, and to charge and discharge the integral capacity 388 by means of the gate leak current of the test element 372.

The integral capacity 388 charges and discharges by means of the gate leak current outputted from the source terminal and the drain terminal of the test element 372. That is, the integral capacity 388 integrates the gate leak current and converts it into a voltage value. In addition, the reset transistors 378, 380, when receiving the rest signal ϕ_{RES} at the gate terminal, initialize the voltage value at the integral capacity 388 to the predetermined voltage V_{R1}.

The output transistor 390 receives a voltage at the integral capacity 388 in the gate terminal thereof, and outputs a source voltage that is in accordance with the voltage. The column selecting transistor 392 outputs a source voltage of the output transistor 390 to the column selecting transistor 306, according to the signal from the row selecting section (VSR) 304.

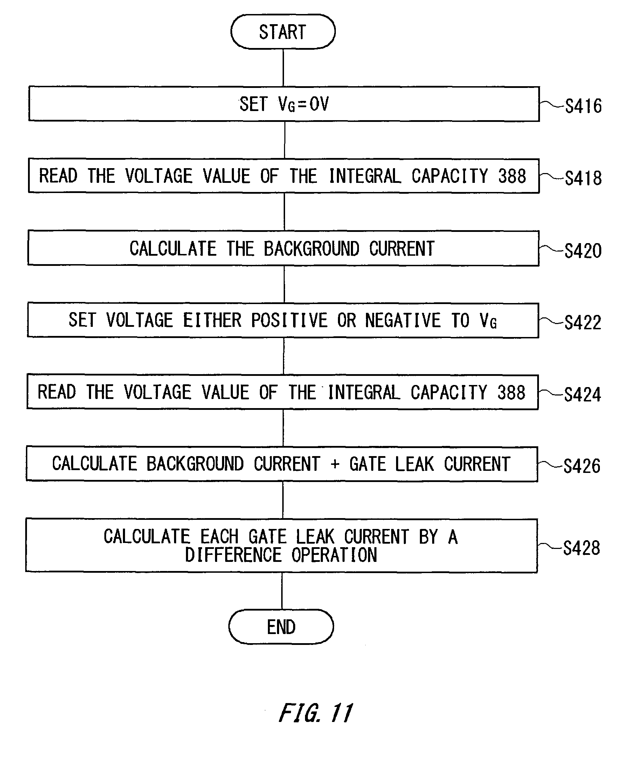

Fig. 11 is a flowchart showing one example of a device identifying method for measuring a gate leak current for each test element 372, and generating identification information of the electronic device 510. The processing of S416 - S428 in Fig. 11 may be performed as property measuring S430 described above with reference to Fig. 6. Prior to measuring the gate leak current for each test element 372, the control section 14 first applies an electric stress to the test element 372 in each cell 310.

During this operation, the control section 14 controls the first switch 374 to the ON state, and the second switch 376 to the OFF state. Then the control section 14 controls the stress applying section 394 in each cell 310 to apply a stress to the test element 372. In addition, the control section 14 may apply the stress of (1) - (4) explained above with reference to Fig. 10 independently or sequentially to the test element 372. In addition, the control section 14 applies a stress to the test element 372 in each cell 310 at substantially the same time.

After performing the above operation, the control section 14 sequentially selects each test element 372, and measures the gate leak current of the selected test element 372. However, the operation for selecting the test element 372 is the same as the selecting operation described above with reference to Fig. 5 and Fig. 8, and so the explanation thereof is omitted in the following. In the present example, an operation of measuring the gate leak current of a single test element 372 is described.

First, the control section 14 controls the first switch 372 to the OFF state, and the second switch 376 to the ON state. Then the control section 14 applies a gate voltage of substantially 0V to the gate terminal of the test element 372 (S416). During this operation, a gate leak current is not caused in the test element 372.

Next, the control section 14 sets the voltage of the integral capacity 388 to a predetermined initial voltage value. During this operation, the control section 14 controls the reset transistor 380 to set the initial voltage V_{R1} to the integral capacity 388. The mentioned setting is performed by supplying a reset signal ϕ_{RES} for controlling the reset transistors 378, 380, to the ON state.

Next, the property measuring section 16 reads change in voltage value of the integral capacity 388, during a predetermined time after the voltage of the integral capacity 388 was set to an initial voltage value (S418). During this operation, the control section 14 controls the column selecting section 302 and the row selecting section 304 to select the cell 310. The property measuring section 16 receives a voltage outputted from the output section 320 as a voltage of the integral capacity 388.

Next, the property measuring section 16 calculates a current value (first current value) of the background current of the cell 310, based on the change amount of the voltage outputted from the output section 320 during the predetermined time (S420). During this operation, the test element 372 does not cause a gate leak current, and so the integral capacity 388 charges and discharges by means of the background current. For this reason, it is possible to measure the background current, based on the voltage change of the integral capacity 388 during the predetermined time.

Next, the control section 14 applies a gate voltage of either positive or negative to the gate terminal of the test element 372 (S422). During this operation, the voltages V_{RN} and V_{RP} are controlled, to maintain the voltage applied to the gate-source or the gate-drain of the test element 372 to be substantially constant. During this operation, the test element 372 causes a gate leak current that is in accordance with the gate voltage.

Next, the control section 14 sets the voltage of the integral capacity 388 to a predetermined initial voltage value. Then the property measuring section 16 sets the voltage of the integral capacity 388 to the initial voltage value, and thereafter reads the change of the voltage value of the integral capacity 388 during the aforementioned predetermined time (S424).

Next, the property measuring section 16 calculates a second current value that indicates a summation between a background current and a gate leak current, based on the change amount of the voltage value of the integral capacity 388, during the predetermined time (S426). During this operation, the integral capacity 388 charges and discharges by means of the current of the summation between the background current and the gate leak current. For this reason, it is possible to measure the current of the summation between the background current and the gate leak current, based on the voltage change of the integral capacity 388 during the predetermined time.

Next, the property measuring section 16 calculates the current value of the gate leak current, by subtracting the first current value from the calculated second current value (S428). According to the stated control, it is possible to accurately measure the gate leak current of the test element 372, by excluding the effect of the background current. In addition, since the measurement is performed by integrating the gate leak current, it is possible to measure a minute gate leak current. The property measuring section 16 generates identification information, based on the current value of the gate leak current of each test element 372.

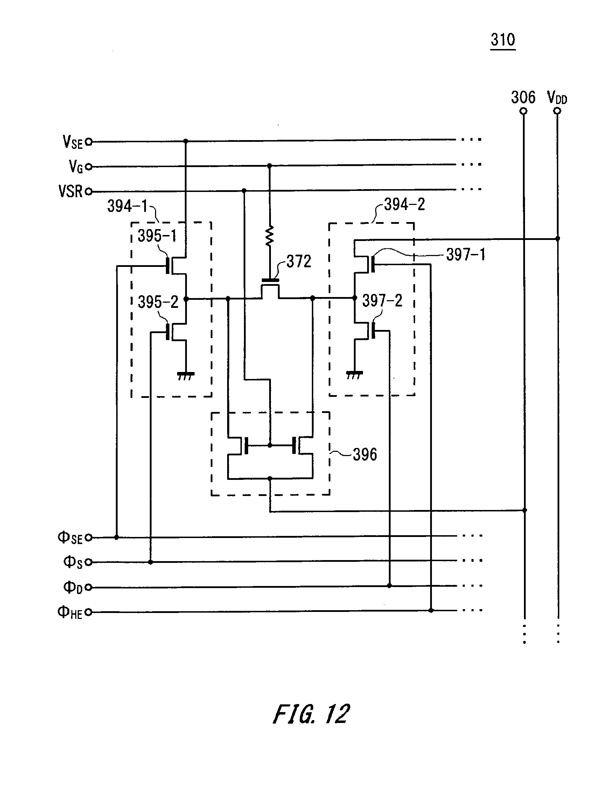

Fig. 12 shows another example of a configuration of a cell 310. To each cell 310 of the present example, voltages V_{DD}, V_{SE}, V_{G}, and signals ϕ_{SE}, ϕ_{S}, ϕ_{D}, ϕ_{HE} are given from the control section 14, and a positional signal resulting from converting a selection signal is given from the row selecting section (VSR) 304.

Each cell 310 includes a test element 372, a stress applying section 394, and a column selecting transistor 396. The stress applying section 394 is supplied with voltages V_{DD}, V_{SE}, and signals ϕ_{SE}, ϕ_{S}, ϕ_{D}, ϕ_{HE}. The stress applying section 394 is connected to the source terminal and the drain terminal of the test element 372, and applies a voltage to the source terminal and the drain terminal of the test element 372 according to a supplied signal.

In the present example, the stress applying section 394 includes a source-side stress applying section 394-1 connected to the source terminal of the test element 372, and a drain-side stress applying section 394-2 connected to the drain terminal of the test element 372.

The source-side stress applying section 394-1 includes two transistors (395-1, 39S-2) provided in series between the bus line supplied with a voltage V_{SE} and a ground potential. In addition, the source-drain connection point for connecting the two transistors (395-1, 395-2) is connected to the source terminal of the test element 372. In addition, a signal ϕ_{SE} is supplied to the gate terminal of the transistor 395-1 at the bus line side. In addition, a signal ϕ_{S} is supplied to the gate terminal of the transistor 395-2 at the ground potential side.

The drain-side stress applying section 394-2 includes two transistors (397-1, 397-2) provided in series between the bus line supplied with a voltage V_{DD} and a ground potential. In addition, the source-drain connection point for connecting the two transistors (397-1, 397-2) is connected to the drain terminal of the test element 372. In addition, a signal ϕ_{HE} is supplied to the gate terminal of the transistor 397-1 at the bus line side. In addition, a signal ϕ_{D} is supplied to the gate terminal of the transistor 397-2 at the ground potential side.

The control section 14 applies a signal ϕ_{SE}, a signal ϕ_{S}, a signal ϕ_{D} and a signal ϕ_{HE} to the stress applying section 394. According to a given signal, the stress applying section 394 applies stresses (1) - (4) described above with reference to Fig. 10, to the test element 372. For example, when applying a stress of (4) Source Erase to the test element 372, the control section 14 supplies a signal ϕ_{S} indicating the H level to the stress applying section 394.

In addition, when applying a stress of (2) FN Substrate injection, the control section 14 may supply a signal ϕ_{SE} indicating the H level. In addition, when applying a stress of (3) Hot Electron injection, the control section 14 may supply a signal ϕ_{HE} indicating the H level. In addition, when applying a stress of (1) FN Gate injection, the control section 14 may supply a signal ϕ_{D} indicating the H level.

In this way, by controlling the signal ϕ_{SE}, the signal ϕ_{S}, the signal ϕ_{D} and the signal ϕ_{HE}, which is performed by the control section 14 according to a stress to be applied, it is possible to apply a voltage that is in accordance to a stress to be applied, to the source terminal and the drain terminal of the test element 372 respectively.

The measuring apparatus 100 measures the gate leak current of the test element 372, after sequentially applying the aforementioned stress to the stress applying section 394. During this operation, a predetermined gate voltage V_{G} is applied to the gate terminal of the test element 372. Then the row selecting section 304 controls the column selecting transistor 396 to the ON state.

The column selecting transistor 396 includes a transistor connected to the source terminal of the test element 372 and being for switching between whether to pass the source current, and a transistor connected to the drain terminal and being for switching between whether to pass the drain current. According to the stated configuration, it is possible to pass the gate leak current whether the test element 372 is P-type or N-type.

In addition, when each cell 310 has the configuration shown in Fig. 12, the output section 320 is supplied with a gate leak current. In the present example, the output section 320 has a function of outputting a current value. In addition, the property measuring section 16 detects a gate leak current property of the test element 372, based on the current value outputted from the output section 320. According to this structure, too, it is possible to measure the gate leak current of each test element 372.

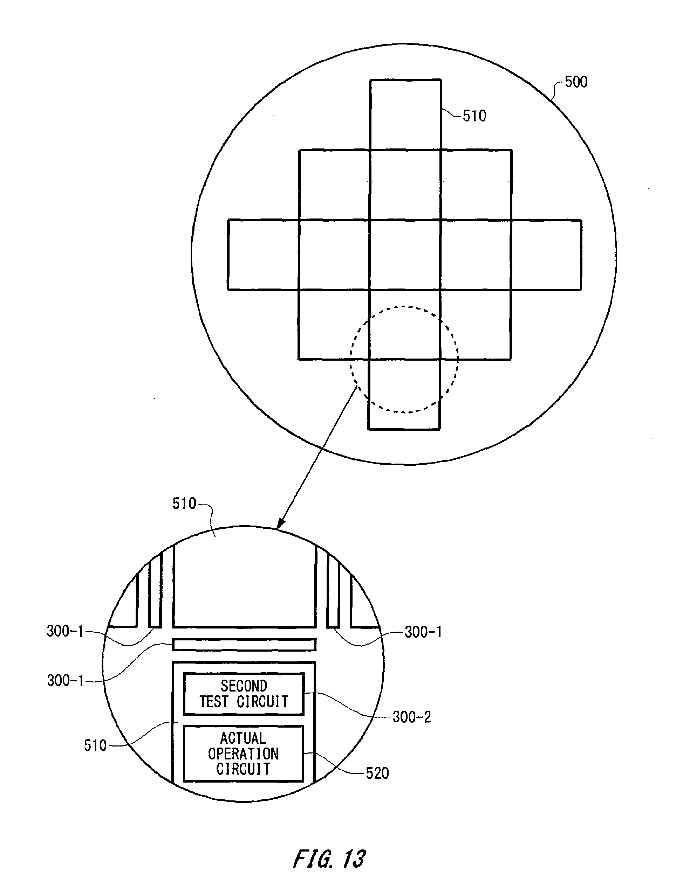

Fig. 13 explains a device manufacturing method for manufacturing the electronic device 510. In the present example, an electronic device 510 including an actual operation circuit 520 operating at the time of actual operation of the electronic device 510, and a test circuit 300 that includes a plurality of test elements 314 and operates at the time of testing of the electronic device 510. Moreover in the present example, an electronic device 510 whose identification information is obtained with use of the measuring apparatus 100 explained in relating to Fig. 1 is manufactured.

First, the actual operation circuit 520 of each electronic device 510 is formed on the wafer 500. The wafer 500 is divided into a plurality of regions for forming a plurality of electronic devices 510, and actual operation circuits 520 are formed in respective divided regions.

Then, a first test circuit 300-1 is formed on the cutting line at which the wafer 500 is cut into electronic devices 510. The first test circuit 300-1 is formed for each electronic device 510. Moreover, a second test circuit 300-2 is formed in a different area from the cutting line of the wafer 500. The second test circuit 300-2 is formed for each divided area in which each electronic device 510 is to be formed. The first test circuit 300-1 and the second test circuit 300-2 may have the same function as that of the test circuit 300 explained above in relation to Fig. 3, Fig. 10, or Fig. 12.

Then in the state where the plurality of electronic devices 510 are formed on the wafer 500, the electronic property of the test element 314 included in the first test circuit 300-1 and the second test circuit 300-2 corresponding to each electronic device 510 is measured. According to the measurement, whether each electronic device 510 passes or fails the test may be judged.

In addition, identification information of the corresponding electronic device 510 is generated based on the electric property of the test element 314 included in the second test circuit 300-2 from among the measured electric properties. The measurement of the electric property and the generation of the identification information are performed by the measuring apparatus 100 by means of the processing explained above in relation to Fig. 4, Fig. 8, Fig. 9, or Fig. 11. Then the identification information storage section 20 stores the identification information generated by the property measuring section 16.

Then by cutting the wafer 500 into electronic devices 510, the electronic device 510 is manufactured. According to the stated processing, it is possible to manufacture the electronic device 510 in the state where the second test circuit 300-2 retaining the identification information for identifying the electronic device 510 is attached to the electronic device 510. In addition, a portion that does not contribute to identification information from among the test circuit 300 for testing the electronic device 510 can be removed, thereby improving the area efficiency of the electronic device 510.

For example, it is preferable to include as many test elements 314 as possible in the first test circuit 300-1 and the second test circuit 300-2, when judging whether the electronic device 510 passes or fails the test based on the variation in electric property of the test element 314 included in the first test circuit 300-1 and the second test circuit 300-2. For example, the test circuit 300 includes about ten thousands (10,000) to a million (1,000,000) test elements 314.

However, the bit number required for the identification information for identifying the electronic device 510 is smaller than the number of the test elements 314 required for accurately calculating the variation of the electronic property. In addition, since the test element 314 does not operate at the time of actual operation of the electronic device 510, the number of test elements 314 included in the electronic device 510 should be as small as possible, in terms of the area efficiency.

In the present example, test elements 314 that are unnecessary in generating identification information is provided in the first test circuit 300-1, and an adequate number of test elements 314 for generating identification information are provided in the second test circuit 300-2. Then the first test circuit 300 is provided on the cutting line of the wafer 500. Accordingly, the first test circuit 300-1 will be removed from the electronic device 510. For this reason, at the time of testing of the electronic device 510, it is possible to measure the electric properties of the sufficient number of test elements 314, as well as reducing the number of test elements 314 included in the electronic device 510 at the time of shipping, and enabling the electronic device 510 to maintain the identification information of the electronic device 510.

In addition, it is preferable that the identification information storage section 20 stores the identification information of each electronic device 510 in association with the manufacturing history information such as the position of the electronic device 510 on the wafer 500. Accordingly, it becomes possible to accurately analyze a cause of a failure of the electronic device 510 or the like, for example.

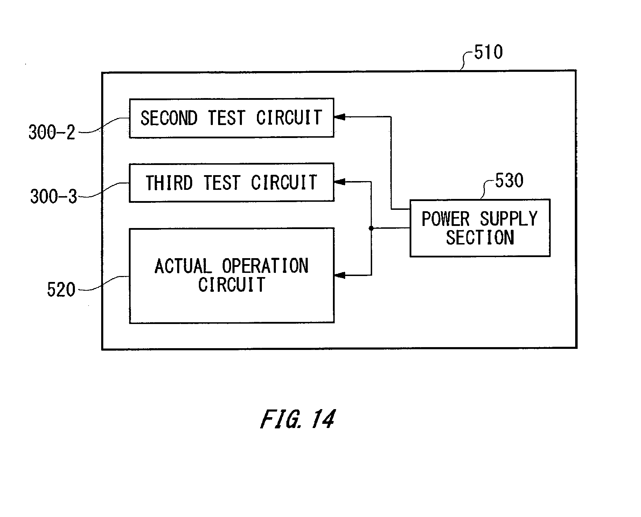

Fig. 14 shows another example of a configuration of the electronic device 510. The electronic device 510 in the present example includes an actual operation circuit 520, a third test circuit 300-3, a second test circuit 300-2, and a power supply section 530.

The actual operation circuit 520 operates at the time of actual operation of the electronic device 510. The third test circuit 300-3 and the second test circuit 300-2 operate at the time of testing of the electronic device 510. The third test circuit 300-3 and the second test circuit 300-2 have substantially the same circuitry configuration as each other. For example, the third test circuit 300-3 and the second test circuit 300-2 may have substantially the same configuration as the configuration of the test circuit 300 explained above in relation to Fig. 3, Fig. 10, or Fig. 12.

The power supply section 530 applies a power supply voltage to the actual operation circuit 520 and the third test circuit 300-3, while maintaining the state where the power supply voltage is not applied to the second test circuit 300-2 at the time of actual operation of the electronic device 510. In addition, the power supply section 530 applies the power supply voltage to the second test circuit 300-2 at the time of identifying the electronic device 510.

According to the stated configuration, it is possible to supply a load that is in accordance with the actual operation environment of the electronic device 510, to the third test circuit 300-3. In addition, since a power supply voltage is not applied to the second test circuit 300-2 at the time of actual operation of the electronic device 510, the deterioration of the electronic property for the test element 314 included in the second test circuit 300-2 is small. For this reason, it is possible to analyze the deterioration according to the usage state of the electronic device 510, by measuring the difference between the electric property of the test element 314 included in the third test circuit 300-3 and the electric property of the test element 314 included in the second test circuit 300-2.

In addition, the measuring apparatus 100 stores identification information based on the electric property of the test element 314 included in the second test circuit 300-2 in advance, and when identifying the electronic device 510, obtains identification information based on the electric property of the test element 314 included in the second test circuit 300-2. Since the deterioration of the electric property of the test element 314 included in the second test circuit 300-2 is small, it is possible to accurately identify the electronic device 510.

It is preferable that the power supply section 530 applies substantially the same power supply voltage both to the actual operation circuit 520 and the third test circuit 300-3. That is, it is preferable to supply substantially the same load to the third test circuit 300-3 as to the actual operation circuit 520. Accordingly, the deterioration of the test element 314 included in the third test circuit 300-3 can be made to be substantially the same as the deterioration of the element included in the actual operation circuit 520. The power supply section 530 may supply the power supply voltage to the third test circuit 300-3 and to the actual operation circuit 520 by means of branching. According to the stated configuration, when the power supply voltage is applied to the actual operation circuit 520, it becomes possible to simultaneously apply the power supply voltage to the third test circuit 300-3. For this reason, it is possible to apply the power supply voltage to the actual operation circuit 520 and the third test circuit 300-3 during substantially the same time.

In addition, it is preferable that the power supply section 530 includes a first power supply line for applying the power supply voltage to the actual operation circuit 520 and the third test circuit 300-3, and a second power supply line being provided independent from the first power supply line and for applying the power supply voltage to the second test circuit 300-2.

In addition, the third test circuit 300-3 includes: test elements provided to be electrically parallel, a selecting section for controlling each test element to the ON state sequentially at the time of testing of the electronic device 510, a property outputting section for sequentially outputting the terminal voltage of the test element controlled to the ON state sequentially by the selecting section, and a state maintaining section for maintaining a plurality of test elements to the ON state at the time of actual operation of the electronic device.

For example, when the third test circuit 300-3 has the circuitry configuration as explained above in relation to Fig. 3, the column selecting section 302, the row selecting section 304, the column selecting transistor 306, and the row selecting transistor 316 will function as the selecting section. In addition, the output section 320 functions as the property outputting section. In addition, the power supply section 530 supplies the voltage V_{DD}, the voltage V_{G}, the voltage ϕⱼ, and the voltage V_{REF} explained above in relation to Fig. 3, to the third test circuit 300-3. During this operation, the power supply section 530 may function as the state maintaining section, by supplying the voltage ϕⱼ that controls all the switching transistors 312 to the ON state.

In addition, the second test circuit 300-2 includes: a plurality of test elements provided to be electrically parallel, a selecting section for controlling each test element to the ON state sequentially at the time of testing of the electronic device 510, and an identification information outputting section for outputting the terminal voltage of each test element controlled to the ON state sequentially by the selecting section, as the identification information of the electronic device 510.

For example, when the second test circuit 300-2 has the circuitry configuration as explained above in relation to Fig. 3, the column selecting section 302, the row selecting section 304, the column selecting transistor 306, and the row selecting transistor 316 will function as the selecting section. In addition, the output section 320 functions as the identification information outputting section.

Although the present invention has been described by way of exemplary embodiments, it should be understood that those skilled in the art might make many changes and substitutions without departing from the spirit and the scope of the present invention which is defined only by the appended claims.

### INDUSTRIAL APPLICABILITY

As the above explanation, according to some aspects of the present invention, it is possible to obtain information for identifying an electronic device. Moreover, since the electric property of a test element provided for evaluating the property of the electronic device is stored as identification information, it becomes unnecessary to provide a dedicated configuration for assigning identification information to the electronic device. This contributes to improvement in area efficiency, manufacturing efficiency, or the like, for the electronic device.

## Claims

1. A device identifying method for identifying an electronic device including an actual operation circuit operating at a time of actual operation of the electronic device and a test circuit provided with a plurality of test elements and operating at a time of testing of the electronic device, the device identifying method comprising:
a property measuring step of measuring electric properties respectively of the plurality of test elements;
an identification information storing step of storing the electric properties respectively of the plurality of test elements, as identification information of the electronic device;
an identification information obtaining step of measuring, in an attempt to identify a target electronic device, electronic properties of a plurality of test elements included in the target electronic device, thereby obtaining identification information of the target electronic device; and
a matching step of comparing the identification information obtained in the identification information obtaining step and the identification information stored in the identification information storing step, and judging that, when there is matching in identification information, the target electronic device whose identification information is obtained in the identification information obtaining step is the electronic device whose identification information is stored in the identification information storing step.

2. The device identifying method as set forth in Claim 1, wherein
in the property measuring step, the electric properties of the plurality of test elements are measured in a state where a plurality of electronic devices are formed on a same wafer, and
in the identification information obtaining step, the electronic properties of the plurality of test elements are measured in a state where the wafer is cut to separate the plurality of electronic devices from each other.

3. The device identifying method as set forth in Claim 1, wherein
in the identification information storing step, information indicating, for each test element, whether the electric property of the test element is larger than a predetermined first reference value is stored as the identification information, and
in the identification information storing step, information indicating, for each test element, whether the electric property of the test element is larger than a second reference value that is different from the first reference value is obtained as the identification information.

4. The device identifying method as set forth in Claim 3, further comprising:
an evaluation step of, when there is matching in identification information in the matching step, evaluating deterioration of the target electronic device based on a difference between the electric properties measured in the property measuring step and the electric properties measured in the identification information obtaining step.

5. A device manufacturing method of manufacturing an electronic device including an actual operation circuit operating at a time of actual operation of the electronic device and a test circuit provided with a plurality of test elements and operating at a time of testing of the electronic device, the device manufacturing method comprising:
an actual circuit forming step of forming the actual operation circuit of each electronic device on a wafer;
a first test circuit forming step of forming a first test circuit on a cutting line at which the wafer is cut into each electronic device;
a second test circuit forming step of forming a second test circuit in a different area from the cutting line of the wafer;
a property measuring step of measuring electric properties of the test elements included in each test circuit;
an identification information storing step of storing electronic properties of test elements included in the second test circuit from among the electronic properties measured in the property measuring step, as identification information of a corresponding electronic device; and
an cutting step of cutting the wafer into each electronic device.

6. The device manufacturing method as set forth in Claim 5, wherein
in the identification information storing step, the identification information of each electronic device is stored in association with a position of the electronic device on the wafer.

7. An electronic device comprising:
an actual operation circuit that operates at a time of actual operation of the electronic device;
a third test circuit and a second test circuit that operate at a time of testing of the electronic device; and
a power supply section that, at the time of actual operation of the electronic device, applies a power supply voltage to the actual operation circuit and the third test circuit while maintaining a state of not applying a power supply voltage to the second test circuit, and that, at a time of identifying the electronic device, applies a power supply voltage to the second test circuit.

8. The electronic device as set forth in Claim 7, wherein
the power supply section applies substantially the same power supply voltage both to the actual operation circuit and the third test circuit.

9. The electronic device as set forth in Claim 7, wherein
the third test circuit and the second test circuit have substantially the same circuitry configuration as each other.

10. The electronic device as set forth in Claim 7, wherein
the second test circuit includes:
a plurality of test elements provided to be electrically parallel;
a selecting section that controls each test element to the ON state sequentially at the time of testing of the electronic device; and
an identification information outputting section that outputs each terminal voltage of each test element controlled to the ON state sequentially by the selecting section, as identification information of the electronic device.

11. The electronic device as set forth in Claim 10, wherein
the third test circuit includes:
a plurality of test elements provided to be electrically parallel;
a selecting section that controls each test element to the ON state sequentially at the time of testing of the electronic device;
a property outputting section that sequentially outputs the terminal voltage of each test element controlled to the ON state sequentially by the selecting section; and
a state maintaining section that maintains the plurality of test elements to the ON state at the time of actual operation of the electronic device.
